(19) Europäisches Patentamt
European Patent Office
Office européen des brevets

(11) **EP 4 145 142 A1**

(12) **EUROPEAN PATENT APPLICATION**

(43) Date of publication:
**08.03.2023 Bulletin 2023/10**

(21) Application number: **21194949.0**

(22) Date of filing: **05.09.2021**

(51) International Patent Classification (IPC):
*G01R 13/02* (2006.01)    *G01R 19/25* (2006.01)
*H03M 3/00* (2006.01)    *G01N 27/00* (2006.01)

(52) Cooperative Patent Classification (CPC):
**G01R 19/2509**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Katholieke Universiteit Leuven KU Leuven Research & Development 3000 Leuven (BE)**

(72) Inventors:
• LI, Peishuo
  **2610 Wilrijk (BE)**
• VERHELST, Marian
  **2800 Mechelen (BE)**

(74) Representative: **DenK iP bv**
  **Leuvensesteenweg 203**
  **3190 Boortmeerbeek (BE)**

(54) **BUFFERED WAVEFORM READOUT**

(57) In a first aspect, the present invention relates to a method for reading out a waveform, comprising: (a) converting the waveform into discrete digital output data (10); (b) buffering the discrete digital output data (10) by (b1) storing a first $n$ consecutive data points $[d_1, d_2, ..., d_n]$ (11) in registers (21) in such a way that the registers (21) are in a state $[d_1, d_2, ..., d_n]$ at the end of step b1, (b2) adding a subsequent $n$ consecutive data points $[d_1, d_2, ..., d_n]$ (11) to the registers (21) in such a way that the registers (21) are in a state $[r_1, r_2, ..., r_n]$ at the start of step b2 and in a state $[r_1 + d_1, r_2 + d_2, ..., r_n + d_n]$ at the end of step b2, and (b3) optionally repeating step b2 a selected number of times; and (c) outputting the data accumulated in the registers (21).

**FIG 2**

**Description**

**Technical field of the invention**

The present invention relates to waveform measurements-especially wherein the sampling rate is high, e.g. because the waveform has a high frequency-; and in particular to readout methods and circuitry therefor.

**Background of the invention**

In state of the art chip designs for e.g. high-frequency impedance measurements, a voltage or current waveform-typically a sine wave-is measured from the sample under test. By sending the measured (sine) waveform to a mixer, the direct current (DC) information is extracted for impedance determination. This DC information can then be sent directly off-chip for further processing as an analog or digital signal, without needing a large input/output (IO) data rate for the chip. However, said mixer significantly increases the chip area and power consumption. Moreover, the working frequency band of the mixer is decided by the analog hardware design, making it difficult later reconfigure the impedance measurement frequency range.

Removing the mixer from the signal path could save power and area, but sending the 'raw' high-frequency measurement data off-chip requires an extra-high-speed IO interface, such as a low-voltage differential signalling (LVDS). Such extra-high-speed IO interfaces are typically costly and therefore not typically a practical option.

The above is described for high-frequency (electrical) waveforms, yet the same considerations apply more generally-irrespective of the waveform's actual frequency-to a high sampling rate (i.e. measurement rate). Indeed, it is more directly the sampling rate which determines the amount of data that is collected and thus must be transmitted. The impact of the waveform frequency is instead rather indirect, in that accurately measuring a high frequency waveform requires a high sampling rate.

There is thus still a need in the art for ways of to readout a waveform that address at least some of the challenges outlined above.

**Summary of the invention**

It is an object of the present invention to provide a good method for reading out a waveform. It is a further object of the present invention to provide good circuitry, devices and uses associated therewith. This objective is accomplished by methods, readout circuitry, potentiostats and uses according to the present invention.

It is an advantage of embodiments of the present invention that a data rate (e.g. bit rate) needed to output (e.g. send off-chip) measurement data can be considerably reduced.

It is an advantage of embodiments of the present invention that they are particularly effective when the sampling rate is high. It is a further advantage of embodiments of the present invention that they are particularly effective for high-frequency waveforms, which require a high sampling rate to be measured accurately.

It is an advantage of embodiments of the present invention that the magnitude and phase information of the waveform can be retained.

It is an advantage of embodiments of the present invention that the buffering can maintain the accuracy and precision of the waveform converted into digital output data. Indeed, by buffering the full data-rather than selecting only a portion of the data for outputting-the accuracy and precision can be maintained.

It is an advantage of embodiments of the present invention that they have a relatively low footprint and power consumption (e.g. as compared to known systems using a mixer).

It is an advantage of embodiments of the present invention that they can be fairly easily adapted to measure waveforms of a different frequency.

It is an advantage of embodiments of the present invention that they can be applied to various waveforms. Indeed, although the background section approaches the issue from the angle of measurements on electrical waveforms, the solution is not limited to any particular type of waveform-so long as it is convertible into digital data.

It is an advantage of embodiments of the present invention that they can be realized in a relatively straightforward and economical fashion.

In a first aspect, the present invention relates to a method for reading out a waveform, comprising: (a) converting the waveform into discrete digital output data; (b) buffering the discrete digital output data by (b1) storing a first n consecutive data points $[d_1, d_2, ..., d_n]$ in registers in such a way that the registers are in a state $[d_1, d_2, ..., d_n]$ at the end of step b1, (b2) adding a subsequent n consecutive data points $[d_1, d_2, ..., d_n]$ to the registers in such a way that the registers are in a state $[r_1, r_2, ..., r_n]$ at the start of step b2 and in a state $[r_1 + d_1, r_2 + d_2, ..., r_n + d_n]$ at the end of step b2, and (b3) optionally repeating step b2 a selected number of times; and (c) outputting the data accumulated in the registers.

In a second aspect, the present invention relates to a readout circuitry for a waveform sensor, comprising: (i) an analog-to-digital converter for converting a waveform into discrete digital output data; and (ii) an output buffer having a plurality of registers; wherein the readout circuitry is arranged for cyclically accumulating the digital output data in the plurality of registers.

In a third aspect, the present invention relates to a potentiostat, comprising the readout circuitry according to any embodiment of the second aspect.

In a fourth aspect, the present invention relates to a use of an output buffer having a plurality of registers in a readout circuitry for a waveform sensor, the readout circuitry-in operation-outputting data, for reducing a data rate (e.g. bit rate) to output said data.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

FIG 1 schematically depicts a waveform having a number of equivalent points marked.

FIG 2 schematically illustrates a method and readout circuitry in accordance with embodiments of the present invention.

FIG 3 schematically depicts a single-channel potentiostat.

FIG 4 schematically depicts a multi-channel potentiostat as proposed in an illustrative example of the present invention.

FIG 5 is a schematic representation of a system architecture in accordance with an illustrative example of the present invention.

FIG 6 is a schematic representation of a current-steering digital-to-analog converter (IDAC) block diagram in accordance with an illustrative example of the present invention.

FIG 7 is a schematic representation of a readout circuitry in accordance with an illustrative example of the present invention.

FIG 8 is a schematic representation of a digital feedback controller block diagram in accordance with an illustrative example of the present invention.

FIG 9 is a scatter plot of the IDAC range in accordance with an illustrative example of the present invention.

FIG 10 is a scatter plot of the IDAC non-linearity in accordance with an illustrative example of the present invention.

FIG 11 is a graph of the analog-to-digital (ADC) integral nonlinearity (INL) in accordance with an illustrative example of the present invention.

FIG 12 is a graph of the ADC differential nonlinearity (DNL) in accordance with an illustrative example of the present invention.

FIG 13 is graph of the measured 50mV/s cyclic voltammetry (CV) in accordance with an illustrative example of the present invention.

FIG 14 is graph of the potential/current waveform in accordance with the CV measurement of FIG 13.

FIG 15 is graph of the measured impedance magnitude in accordance with embodiments of the present invention.

FIG 16 is graph of the potential/current waveform at 150kHz in accordance with the impedance measurement of FIG 15.

FIG 17 is a micrograph of a chip in accordance with embodiments of the present invention.

In the different figures, the same reference signs refer to the same or analogous elements.

**Description of illustrative embodiments**

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practised without these specific details. In other instances, well-known methods, structures and techniques have not been shown in detail in order not to obscure an understanding of this description.

In a first aspect, the present invention relates to a method for reading out a waveform, comprising: (a) converting the waveform into discrete digital output data; (b) buffering the discrete digital output data by (b1) storing a first $n$ consecutive data points $[d_1, d_2, ..., d_n]$ in registers in such a way that the registers are in a state $[d_1, d_2, ..., d_n]$ at the end of step b1, (b2) adding a subsequent $n$ consecutive data points $[d_1, d_2, ..., d_n]$ to the registers in such a way that the registers are in a state $[r_1, r_2, ..., r_n]$ at the start of step b2 and in a state $[r_1 + d_1, r_2 + d_2, ..., r_n + d_n]$ at the end of step b2, and (b3) optionally repeating step b2 a selected number of times; and (c) outputting the data accumulated in the registers.

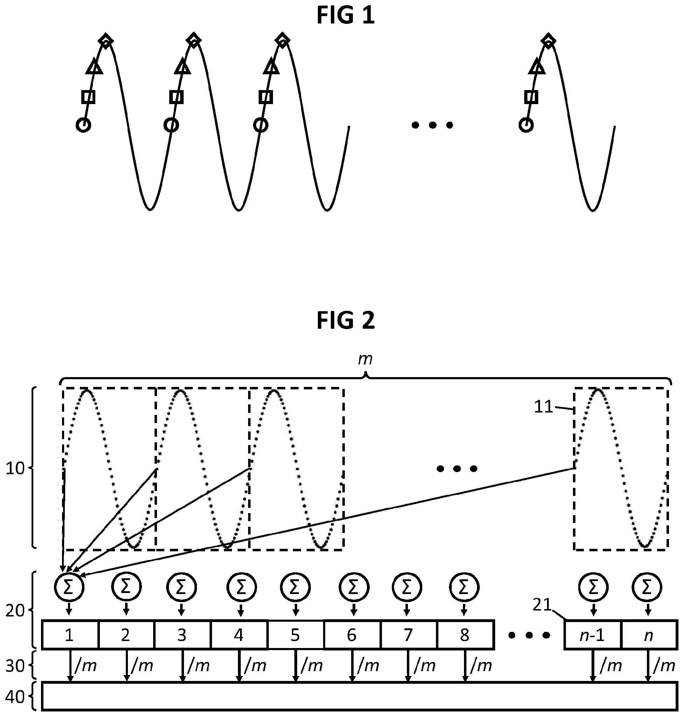

Since waveforms are periodical, each period is made up of equivalent points. This is schematically depicted in FIG 1 in the form of the different series of circles, squares, triangles and diamonds; each series marking equivalent points across the different periods. Accordingly, after converting the waveform into discrete digital output data-schematically depicted in FIG 2 as the dotted waveform (10)-these equivalent points across different periods are typically not perfectly identical (e.g. due to small measurement variations) but nevertheless typically differ only slightly. Transmitting-off-chip or to a different area on the chip-each of these data points as such therefore involves sending a lot of redundant information. Moreover, such measurement variations are typically not the information that is sought after. Sending (unneeded) redundant information is never desirable, but is especially problematic when the transmitting is-or can be-a bottleneck; e.g. due to bandwidth limitations of the employed data interface (40). This becomes increasingly relevant as the sampling rate (i.e. measurement rate) increases, because this in turn increases the amount of data that needs to be transmitted. A high sampling rate is for example needed to accurately measure high-frequency waveforms (e.g. 1 kHz or above, cf. infra).

The inventors therefore presently foresaw a way to buffer the data (e.g. on-chip) before transmitting it (e.g. off-chip or to a different area on the chip). The approach involves in step b1 storing a first $n$ consecutive data points ($[d_1, d_2, ..., d_n]$) in a different register each (so that the registers are in a state $[d_1, d_2, ..., d_n]$). Subsequently, the next n consecutive data points ($[d_1, d_2, ..., d_n]$) are in step b2 added to the register by summing them up to the values already stored therein (so that the registers are in a state $[r_1, r_2, ..., r_n]$ at the start of said step and in a state $[r_1 + d_1, r_2 + d_2, ..., r_n + d_n]$ at the end of said step). Next, step b2 can optionally be repeated a selected number of times $m - 2$ (i.e. actual repetitions, without counting step b2 itself) in step b3.

Accordingly, data is accumulated in the registers a total of $m$ times: once in step b1, once in step b2 and $m - 2$ times in step b3. Each of these-i.e. step b1, step b2 and each repetition in step b3-will herein further be referred to as an 'accumulation cycle'; with $m$ thus being the total number of accumulation cycles. In embodiments, step b2 may be repeated at least 6 times (i.e. $m$ may be at least 8), preferably at least 14 times (i.e. $m$ may be at least 16), more preferably at least 30 times (i.e. $m$ may be at least 32), most preferably at least 62 times (i.e. $m$ may be at least 64).

Note that-as defined *herein*-$n$ and $m$ remain the same across accumulation cycles, but the parameters $d_1, d_2, ..., d_n$ and $r_1, r_2, ..., r_n$ are "reinitialized" in every accumulation cycle. In other words, e.g. $d_1$ in step b2 is typically not (exactly) equal to $d_1$ in step b1; nor is it in general to any repetition of step b2 in step b3. Likewise, e.g. $r_1 + d_1$ at the end of step b2 becomes $r_1$ at the start of the subsequent repetition.

In embodiments, $n$ consecutive data points (e.g. the data points of one aggregation cycle) may correspond to a period of the waveform, or to an integer multiple of said periods. Doing so results in the data points being accumulated in any given register all being equivalent points across different periods. This is schematically depicted in FIG 2 by the four arrows starting from the starting points of the four depicted periods and pointing to the first register (21), where they are added up. The second point of each period would then be accumulated (not depicted) in the second register (21); etc. up the n-th point of each period being accumulated in the n-th register (21). Likewise, if the window of one aggregation cycle (11) covers an integer multiple of periods (e.g. 2, 3, 4, etc.), the same effect is achieved, while an equivalent number of periods is stored across the registers (21) per aggregation cycle (11). By only adding together equivalent points, the data aggregated in the registers advantageously retains the magnitude-though multiplied $m$-and phase information of the waveform.

Nevertheless, it is conceivable that for some applications, the relation between n and the waveform period could be different. For instance, for an application where only the average amplitude-without the phase information-is needed, it could make sense to have n consecutive data points correspond to half a period of the waveform.

In embodiments, $n$ may be at least 8, preferably at least 16, more preferably at least 32, most preferably at least 64. Typically, $n$ is more or less fixed-e.g. because the output buffer (cf. infra) has a fixed number of registers-; though one could always choose to not employ all available registers. However, the relation between the $n$ consecutive data points and the period of the waveform (i.e. the number of periods per accumulation cycle) can be controlled through selecting an appropriate sampling rate in relation to the frequency of the waveform:

$$\text{number of periods per accumulation cycle} = \frac{n \times \text{waveform frequency}}{\text{sampling rate}}.$$

For example, if $n$ is 64 and the sampling rate is 64 times the waveform frequency, then one accumulation cycle corresponds to exactly one waveform period; if $n$ is 64 and the sampling rate is 16 times the waveform frequency, then one accumulation cycle corresponds to exactly 4 waveform periods; etc. This also entails that one can advantageously fairly easily adapt to a different waveform frequency, by changing the sampling rate and/or the number of periods per accumulation cycle (and/or $n$, by not using all registers).

After having buffered the discrete digital output data in step b, the data accumulated in the registers is output in step c. This may take different forms, e.g. depending on whether step d (cf. infra) is present. If step c is followed by step d, outputting the data accumulated in the registers may simply be outputting said data to step d (e.g. to an averaging module therefor; cf. infra). If step c is not followed by step d, outputting the data accumulated in the registers may be transmitting said data off-chip or to a different area on the chip (e.g. through a data interface; cf. infra).

In embodiments, the method may comprise a further step d of: (d) dividing each datapoint outputted in step c by $m$ and outputting the resulting data. Dividing the data accumulated in one register by the total number of data accumulation cycles $m$ advantageously yields the average of the data points stored in that register. Such averaging is not strictly required-and could be done at a later stage, e.g. after having sent the data off-chip-it is nevertheless advantageous to do so shortly after step c and at least before a data bandwidth bottleneck (e.g. a data interface such as SPI; cf. infra), because fewer bits are needed for the averaged result than for the (non-averaged) accumulated total. Accordingly, outputting the averaged data advantageously requires a lower bit rate than outputting the data accumulated in the registers as such.

In embodiments, steps a, b, c and-if present-d may be cyclically repeated. Accordingly, the data accumulated in the registers may be-optionally after averaging-outputted periodically.

Although the present invention is in principle not limited to any particular type of waveform-so long as it is convertible into digital data-, the waveform may more specifically be an electrical waveform (e.g. a voltage or a current waveform). The present approach has at least-to the best of our knowledge-never been contemplated for use in the context of measuring electrical waveforms (e.g. using a potentiostat). This is for example evidenced by the challenges as outlined in the Background section being unresolved before now. In embodiments, the electrical waveform may be a waveform in a (high-frequency) impedance measurement.

In embodiments, the sampling rate-which is numerically equal to the sampling frequency (in Hz), but uses the unit 'samples per second' (sps)-may be at least 8 Ksps, preferably at least 50 Ksps, more preferably at least 200 Ksps, yet more preferably at least 500 Ksps, such as at least 1 Msps. In embodiments, the sampling rate may be up to 1 Gsps or even higher, preferably 100 Msps or lower, more preferably 64 Msps or lower. Although the sampling rate can in principle be rather extremely high (e.g. integrated circuits as used for the present invention can support a sampling rate in the order of Gsps), using such an extremely high sampling rate when the frequency of the waveform to be measured is not similarly high entails $n$ must be exceedingly high to still cover a full period. Accordingly, this means that also the number of registers (e.g. in the output buffer; cf. infra) must be at least equal to $n$, which could entail a significant increase in hardware costs. Moreover, a high sampling rate increase the data to be output, and thus must be accumulated longer (i.e. higher $m$) if the data rate is to be kept below a certain threshold. More accumulation requires a larger register size (i.e. for each of the registers) and thus also comes with an increased hardware cost. For these reasons, it may for the waveform frequency ranges typically encountered be desirable to suitably limit the sampling rate.

In embodiments, the waveform may have a frequency of at least 1 kHz, preferably at least 10 kHz, more preferably at least 50 kHz, such as at least 100 kHz. In embodiments, the waveform may have a frequency of up to 10 MHz or higher, preferably 1 MHz or lower, more preferably 500 kHz or lower. For example, the waveform may have a frequency between 1 kHz and 1 MHz, such as between 50 and 500 kHz. In applications wherein the waveform frequency can be controlled-such as in impedance measurement, wherein the waveform frequency is function of the applied stimulation signal-it may be desirable to limit the frequency (e.g. to 1 MHz or lower) to not drive up the needed sampling rate and thus avoided the potential negative consequences thereof as outlined above. In embodiments, the waveform may be a sine wave. In embodiments, the waveform is typically an analog waveform.

In embodiments, any feature of any embodiment of the first aspect may independently be as correspondingly described for any embodiment of any of the other aspects.

In a second aspect, the present invention relates to a readout circuitry for a waveform sensor, comprising: (i) an analog-to-digital converter for converting a waveform into discrete digital output data; and (ii) an output buffer having a plurality of registers; wherein the readout circuitry is arranged for cyclically accumulating the digital output data in the plurality of registers.

The readout circuitry can advantageously be used in performing the method in accordance with the first aspect. More in particular, the analog-to-digital converter is able to convert the waveform into discrete digital output data in accordance with step a and the output buffer has the plurality of registers in which the discrete output data is buffered in step b. In embodiments, the analog-to-digital converter (e.g. an output thereof) may be electrically (e.g. resistively) coupled (e.g. connected) to the output buffer (e.g. to an input thereof).

In embodiments, the readout circuitry may further comprise an output for outputting the data accumulated in the registers and/or the averaged data. The output may for example be a data interface (e.g. an IO interface), such as a serial peripheral interface (SPI). In embodiments, the output (e.g. an input thereof, such as an input of the data interface) may be electrically (e.g. resistively) coupled (e.g. connected) to the output buffer (e.g. to an output thereof).

In embodiments, the readout circuitry being arranged for cyclically accumulating the digital output data in the plurality of registers may entail the readout circuitry comprising a controller therefor. More in particular, the controller may be for operating the other components of the readout circuitry in accordance with the method of the first aspect. In embodiments, the controller (e.g. an output thereof) may be electrically (e.g. resistively) coupled (e.g. connected) to the analog-to-digital converter and/or output buffer and/or averaging module (cf. infra) and/or output (e.g. to an input of these).

In embodiments, the readout circuitry may further comprise an averaging module for dividing data accumulated in the registers by the total number of accumulation cycles *m* (e.g. in accordance with step d the method of the first aspect). The averaging module may be a separate component or may be a function performable by the controller. In embodiments wherein the averaging module is separate component, the averaging module may be electrically (e.g. resistively) coupled (e.g. connected) to the output buffer (e.g. an output of thereof) and/or to the output (e.g. an input thereof).

In embodiments, the waveform sensor may be a potentiostat for measuring a periodic electrical signal. In embodiments, the periodic electrical signal may be a voltage signal or a current signal; preferably a voltage signal.

In embodiments, the readout circuitry may be implemented in an integrated circuit (IC) chip. The readout circuitry may thus be part of a monolithically integrated circuit. In embodiments, the integrated circuit (e.g. the IC of IC chip) may be a metal-oxide-semiconductor (MOS) integrated circuit, preferably a complementary metal-oxide-semiconductor (CMOS) integrated circuit. In embodiments, the integrated circuit may be formed with (deep) sub micron process technology, such as a process technology of 500 nm or lower, preferably 250 nm or lower, more preferably 100 nm or lower, yet more preferably 70 nm or lower, most preferably 50 nm or lower, such as 40 nm or lower.

To allow a high sampling rate of the waveform, the analog-to-digital converter (ADC) is preferably a high-speed ADC. In embodiments, the analog-to-digital converter may be a successive-approximation (SAR) ADC, a sigma-delta ($\Sigma\Delta$) ADC or a noise-shaping successive-approximation (NS-SAR) ADC.

In embodiments, the output buffer may have at least 8 registers, preferably at least 16 registers, more preferably at least 32 registers, most preferably at least 64 registers. The output buffer typically has at n registers (cf. the first aspect). If the number of registers is equal to n, the output buffer is advantageously fully used. Nevertheless, it is conceivable that in embodiments, the number of registers would be larger than n and that some would be idle or not used.

In embodiments, any feature of any embodiment of the second aspect may independently be as correspondingly described for any embodiment of any of the other aspects.

In a third aspect, the present invention relates to a potentiostat, comprising the readout circuitry according to any embodiment of the second aspect.

In embodiments, the potentiostat may be a multichannel potentiostat. For example, the potentiostat may have a plurality of sensing channels and/or a plurality of stimulation channels; preferably at least a plurality of sensing channels. Note however that a particular channel may not necessarily strictly be either a 'sensing channel' or a 'stimulation channel', but may be both (e.g. at the same point in time-i.e. concurrently-, at different times-e.g. sequentially-, or some mix thereof). Notwithstanding, such a channel could still be referred to as 'sensing channel' or 'stimulation channel', e.g. to emphasize the function that is most relevant in a particular context. In embodiments, the multichannel potentiostat may comprise at least 4 sensing channels, preferably at least 8, more preferably at least 16, yet more preferably at least 32, most preferably at least 64, such as 96 or 128 or more. In embodiments, the multichannel potentiostat may comprise at least 4 stimulation channels, preferably at least 8, more preferably at least 16, yet more preferably at least 32, most preferably at least 64, such as 96 or 128 or more.

In embodiments, any feature of any embodiment of the third aspect may independently be as correspondingly described for any embodiment of any of the other aspects.

In a fourth aspect, the present invention relates to a use of an output buffer having a plurality of registers in a readout circuitry for a waveform sensor, the readout circuitry-in operation-outputting data, for reducing a data rate (e.g. bit rate) to output said data.

In embodiments, any feature of any embodiment of the fourth aspect may independently be as correspondingly described for any embodiment of any of the other aspects.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1

A readout circuitry as schematically depicted in FIG 2 was made, having a successive-approximation ADC and an output buffer (20) with 64 registers (21). This readout circuitry was used to measure various electrical (typically voltage) waveforms, for example for impedance measurements. In these measurements, typically *n* and *m* were both 64, the waveform frequency was between 1 kHz and 1 MHz, and the sampling rate was selected such that the number of waveform periods per accumulation cycle (11) was an integer between 1 and 8.

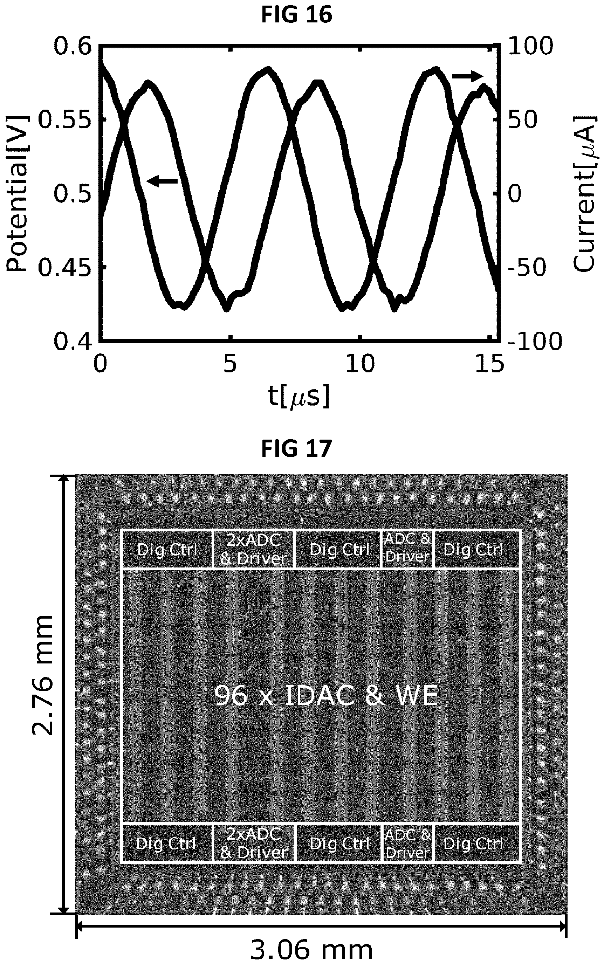

A typical measurement result is depicted in FIG 16. In this measurement, a sine current profile as shown in FIG 16 was applied and yielded a 150 kHz sine potential wave to be measured. The sampling rate was selected such that every sine period was sampled with 16 points. With *n* equal to 64, this thus corresponded to 4 periods per accumulation cycle (11). The number of accumulation cycles *m* was also 64, so that in total 256 periods were measured. As shown in FIG 2, after having converted the waveform into discrete digital output data (10) and buffering said discrete digital output data (10) in the output buffer (20), the accumulated data in each register (21) was averaged (30) by dividing by *m* (i.e. 64) and subsequently the averaged data points was transmitted off-chip over a 20 MHz SPI output (40)-which was sufficient for this task.

Without the buffering in accordance with the present invention, a 20×64 MHz SPI clock would have been needed, which is not possible.

**Example 2: A 96-channel 40nm CMOS Fully-Integrated Potentiostat for Electrochemical Monitoring**

To further illustrate the present invention, a readout circuitry in accordance with the present invention was implemented in a concrete device, namely a 96-channel 40nm CMOS potentiostat chip. The configuration and functioning of the latter are detailed below.

*Abstract*

Multi-channel potentiostats are required for monitoring electrochemical processes in a time- and cost-efficient manner. State-of-the-art printed circuit board (PCB) potentiostats suffer from a limited number of channels and limited bandwidth. Existing integrated complementary metal-oxide-semiconductor (CMOS) potentiostats enable more parallel sensing channels, yet are still limited in the number of parallel stimulation channels and their bandwidth. The presented 40nm CMOS potentiostat chip overcomes this bottleneck with 96 individually controllable channels with 125dB current dynamic range and up to 150kHz bandwidth using an on-chip digital feedback controller. The chip supports both on-chip and off-chip electrodes allowing flexible electrode dimensions.

**I. INTRODUCTION**

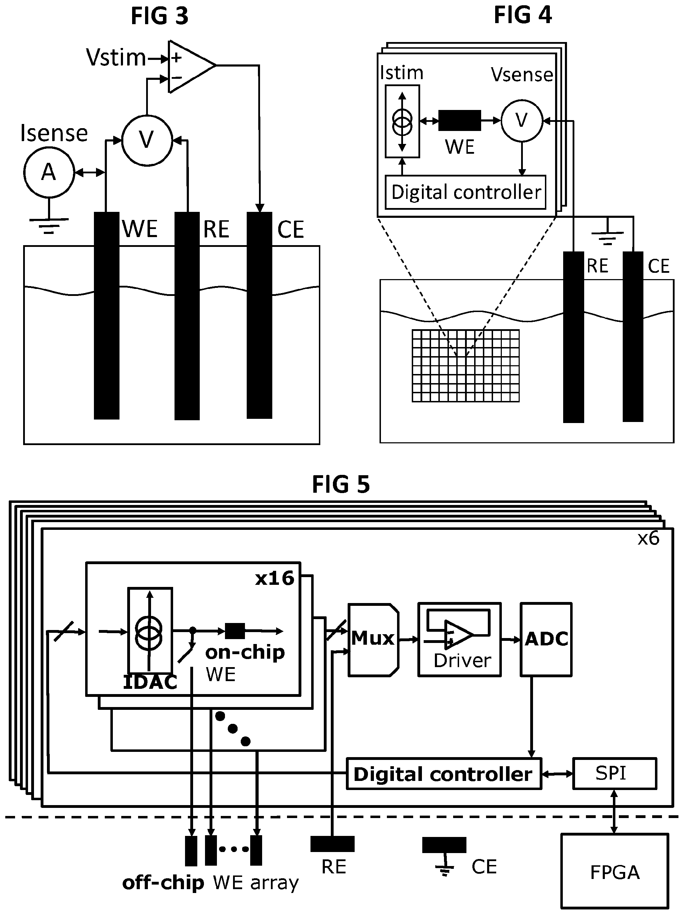

Electrochemical processes are crucial for applications such as microbial synergy, corrosion monitoring and biomolecule sensing. An individual electrochemical process is monitored with a 3-electrode potentiostat setup, shown in FIG 3. The voltage between working electrode (WE) and reference electrode (RE) is stimulated via a counter electrode (CE) to an expected value. Together with the current measured from WE, these are used to characterize the process.

Due to the typically slow reaction time and natural statistical variation of electrochemical processes, a potentiostat with many channels as in FIG 4 is required to perform cost- and time-efficient parallel experiments. The parallel readout circuitry greatly increases experiment throughput when each channel can be stimulated in parallel with different patterns, so that the optimal electrical settings for microbial or anti-corrosion reactors can be explored in a dynamic and accurate way.

In Molderez et al. (MOLDEREZ, Tom R.; RABAEY, Korneel; VERHELST, Marian. A Scalable 128-Channel, Time-Multiplexed Potentiostat for Parallel Electrochemical Experiments. IEEE Transactions on Circuits and Systems I: Regular Papers, 2021, 68.3: 1068-1079.), 128 truly parallel channels are provided to perform chronoamperometry and low scan-rate cyclic voltammetry (CV) with notably speed-up. However, the PCB technology used in this design limits the system miniaturization and the system bandwidth due to routing complexity and large parasitics.

CMOS multi-channel potentiostat allows a large number channels integrated on chip with wider bandwidth. In Lopez et al. (LOPEZ, Carolina Mora, et al. A 16384-electrode 1024-channel multimodal CMOS MEA for high-throughput intracellular action potential measurements and impedance spectroscopy in drug-screening applications. In: 2018 IEEE International Solid-State Circuits Conference-(ISSCC). IEEE, 2018. p. 464-466.), a microelectrode array (MEA) is presented with 16384 electrodes and 1024 parallel readout channels with 10kHz bandwidth. However, the design is focused on high spatial resolution of readout circuitry for extracting cellular information and only 64 parallel stimulation units with low bandwidth are provided. Giagkoulovits et al. (GIAGKOULOVITS, Christos, et al. A 16 x 16 CMOS amperometric microelectrode array for simultaneous electrochemical measurements. IEEE Transactions on Circuits and Systems I: Regular Papers, 2018, 65.9: 2821-2831.), the bandwidth is expanded to 150kHz and a joint cyclic voltammetry is performed with 16 parallel stimulation and readout channels. In Manickam (MANICKAM, Arun, et al. 11.2 A CMOS biosensor array with 1024 3-electrode voltammetry pixels and 93dB dynamic range. In: 2019 IEEE International Solid-State Circuits Conference-(ISSCC). IEEE, 2019. p. 192-194.) and Jung et al. (JUNG, Doohwan, et al. 28.4 A CMOS Multimodality In-Pixel Electrochemical and Impedance Cellular Sensing Array for Massively Paralleled Synthetic Exoelectrogen Characterization. In: 2020 IEEE International Solid-State Circuits Conference-(ISSCC). IEEE, 2020. p. 436-438.) further boost the readout circuit performance with pA sensitivity and more than 90dB dynamic range. Yet the number of independent channels is not larger than 64.

To fulfil the application requirement, a larger number of individually controllable channels are needed, which requires a more area-efficient architecture and circuit design. Moreover, all the state-of-the-art CMOS multi-channel potentiostats rely on custom post-processing to fabricate chemical resistive WE array on chip. Such on-chip electrode processing significantly increases the fabrication cost and the small chip dimension gives constraints on the shape and size of WE.

In this example, a CMOS multi-channel potentiostat is present with the following improvements: 1) an optimized multiplexing architecture with current-stimulation and voltage sensing, allowing 96 parallel stimulation and readout channels; 2) an area-efficient circuit block design resulting in a 125dB current dynamic range and up to 150kHz readout bandwidth; 3) a fully-integrated digital feedback controller, programmable to stimulate each channel with a different custom stimulation pattern; 4) providing connections for both on-chip post-processed electrode and off-chip electrode with flexible dimensions, resulting in a wide range of applications.

This example is structured as follows: First, section II introduces the system architecture. The circuit implementation is discussed in section III. Finally, section IV presents the electrical measurement and chemical cyclic voltammetry results.

## II. SYSTEM ARCHITECTURE

The 96-channel potentiostat consists of three parts: the bipolar current-stimulation/voltage-sensing potentiostat architecture, the multiplexing scheme and the flexible working electrode connection, shown in FIG 5.

### A. Single channel architecture

An area-efficient implementation is essential to realize a large number of independent channels. Traditional CMOS potentiostats apply voltage-stimulation, current-sensing architecture. The required current dynamic range is at least 5 orders of magnitude for impedance measurement up to 100kHz. In order to sense current with such high dynamic range, either an area-consuming trans-impedance amplifier or speed-limited sigma-delta modulator is required. In contrast, this design applies current-stimulation, voltage-sensing with a digital control loop using a proportional-integral (PI) controller. The current stimulator is designed with a configurable high-dynamic-range current-steering digital-to-analog converter (IDAC) and the voltage readout is done with a successive approximation (SAR) analog-to-digital converter (ADC), both can be implemented with high area efficiency and sampling rate.

The potentiostat functionality is defined by the targeted input waveform shape of the potential between WE and RE, e.g., ramp shape for cyclic voltammetry, sine shape for impedance measurement, etc. In the current-stimulation, voltage-sensing architecture, this target potential waveform is realized with an on-chip, high-bandwidth digital feedback controller. This controller compares the target potential and the measured potential from ADC, to control the IDAC to stimulate the system until both are equal.

The power/area overhead due to the digital controller is minimized by using advanced technology (40nm) and hardware sharing.

### B. Potentiostat multiplexing scheme

To further improve area efficiency and make full use of the speed advantage of deep sub-micron technologies, time-multiplexing is exploited. Specifically, the readout circuitry (driver and ADC) and the digital feedback controller are shared across 16 sensing channels. 16-way multiplexing is chosen as a balance between area efficiency and individual channel readout bandwidth. In order to maintain fully independent and continuous stimulation of all channels, the stimulation circuits are not time multiplexed, resulting in one independent IDAC per channel. This 16-channel group is repeated 6 times on the potentiostat chip.

### C. Flexible working electrode connection

Each channel connects to one on-chip electrode implemented as a $60 \times 60 \mu m^2$ top metal square. During post-processing, the passivation layer on top of the metal square can be removed to deposit an electrochemically stable metal such as Au in line with the approach of most state-of-the-art CMOS potentiostats.

In order to provide the additional possibility to bypass the risky and costly post-processing and allow interfacing to electrodes with flexible dimensions, every on-chip electrode is also connected with an external bonding pad. This allows to connect an external electrode array to the chip at PCB level. This external-pad connection can be decoupled to reduce the parasitics for measurement using on-chip electrodes.

## III. CIRCUIT LEVEL DESIGN

### A. IDAC

The targeted current resolution is 10pA, considering the transistor leakage current of this technology. As shown in Jung et al. (cf. supra), approximately 100nA maximum current is needed for impedance measurement up to 100kHz for $44 \times 52 \mu m^2$ electrodes for HEK-293 cancer cell sensing. Additional 3 orders of magnitude (i.e. $100 \mu A$ max current) are targeted here to support a wider range of (bio-)chemical processes.

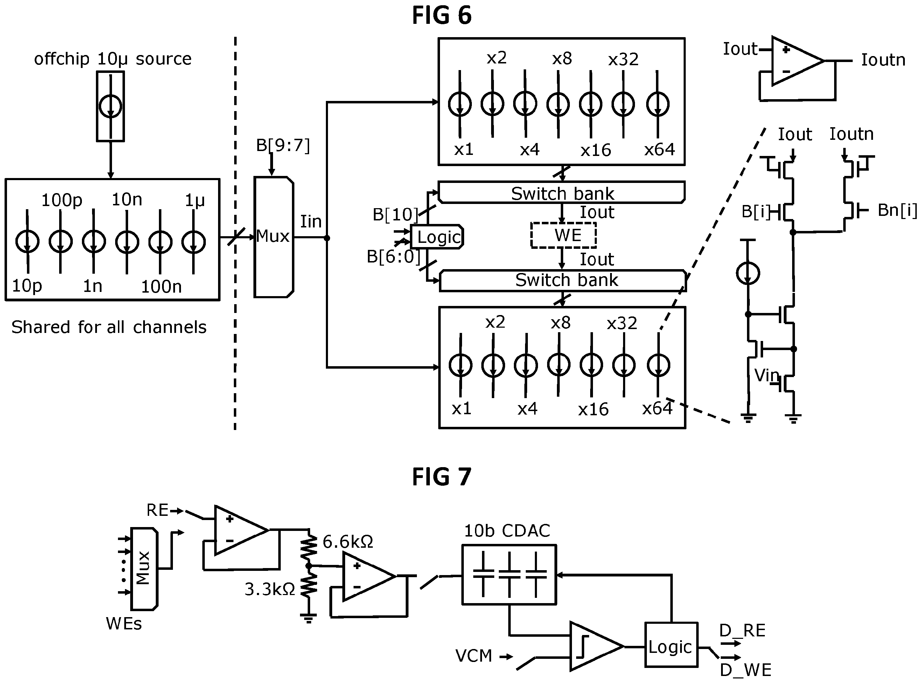

In order to achieve a high dynamic range with limited area, the IDAC design is inspired by the floating point number representation, with an exponent to expand the application range and mantissa to maintain the linearity within a sub-range. As shown in FIG 6, the 3-bit exponent *(B[9:7])* is used to select the input current source for range control and the 7-bit mantissa *(B[6:0])* is used to control the IDAC switch array. The exponent bit length is decided by the current range and implementation overhead for each current source. The mantissa bit length is selected such that there is sufficient overlap between neighbouring ranges and a good trade-off between area and accuracy.

Due to the typically bipolar current requirement for potentiostat applications, each IDAC is composed of a N-channel metal-oxide-semiconductor (NMOS) sub-IDAC to sink current and a P-channel metal-oxide-semiconductor (PMOS) sub-IDAC to source current, controlled by one additional bit *(B[10])*.

To limit the overhead, the different current sources ranging from 10pA to $1 \mu A$ are shared for all 96 channels and generated on chip from an off-chip $10 \mu A$ source with a logarithmic current splitter.

To seek a further balance between linearity and area efficiency, each sub-IDAC is a hybrid design with 4-bit unary, 3-bit binary control. The single IDAC unit is a regulated cascode current mirror to provide high output impedance.

The speed of the IDAC is limited by the switch glitches and parasitic charge injection. To reduce the effects, the switch in each unit is implemented with two cascoded minimum size transistor. The layout is carefully planned to have symmetrical and clean digital control signals without crossing over analog signals. In addition, a bypassable voltage buffer is added between the IDAC main output (*Iout*) and complementary output (*Ioutn*) to minimize the voltage ripple during switching.

### B. Readout circuitry

The readout circuitry is shown in FIG 7. To meet the application requirement, a 10-bit ADC is needed with small area and 10MSps speed. The SAR topology is selected for its excellent area efficiency. To further shrink area and guarantee sufficient speed, the ADC is designed with 0.9V core transistors. To eliminate the range limitation caused by the core supply, the driver is designed with input/output (IO) transistors supporting 2.5V voltage. A resistor divider and an additional driver stage is added to scale down the WE voltage to be below the 0.9V ADC supply.

In order to remove offset and 1/*f* noise, correlated double sampling (CDS) is implemented by sampling RE and one of the WEs alternatively and makes the difference of measured WE and RE voltages in the digital controller.

### C. Digital controller

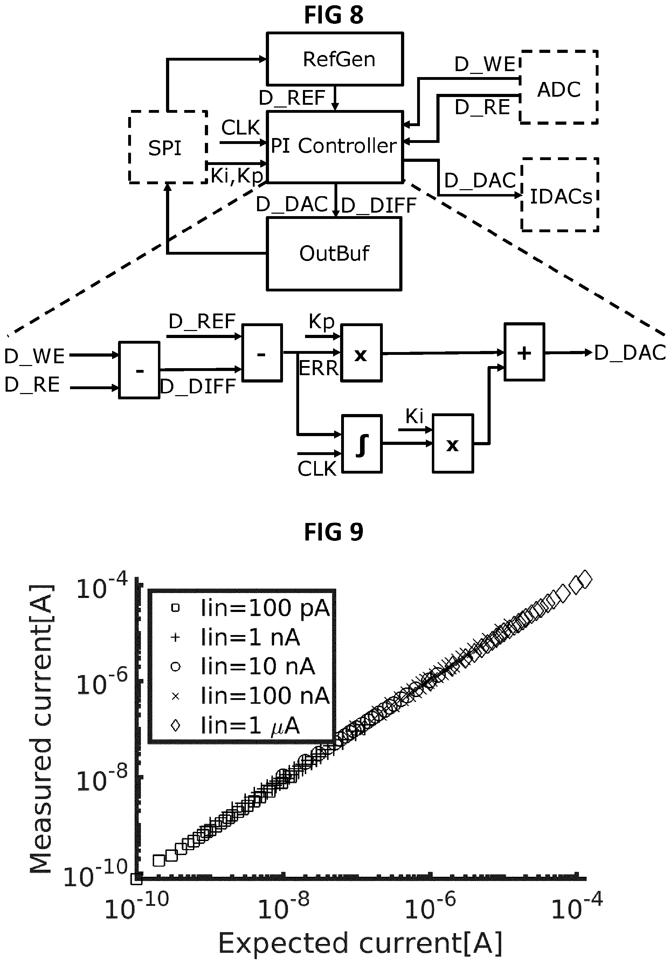

The digital feedback loop makes use of an area-efficient PI controller, as shown in FIG 8. The controller reads the measured WE (*D_WE*) and RE (*D_RE*) voltages from ADC, makes the difference (*D_DIFF*) and compares the result with a target value (*D_REF*). The comparison result controls the input of IDAC (*D_DAC*). Loop stability and bandwidth are programmable through tuning the integral and proportional coefficients (*Ki, Kp*).

The target potential waveform (*D_REF*) can be programmed via a serial peripheral interface (SPI) or generated from an integrated look-up table based waveform generator (*RefGen*). A bypassable output buffer (*OutBuf*) with 64-words is added so that the cyclic-averaged signal (*D_DIFF* and *D_DAC*) can be communicated over SPI.

## IV. MEASUREMENT RESULTS

### A. Block performance

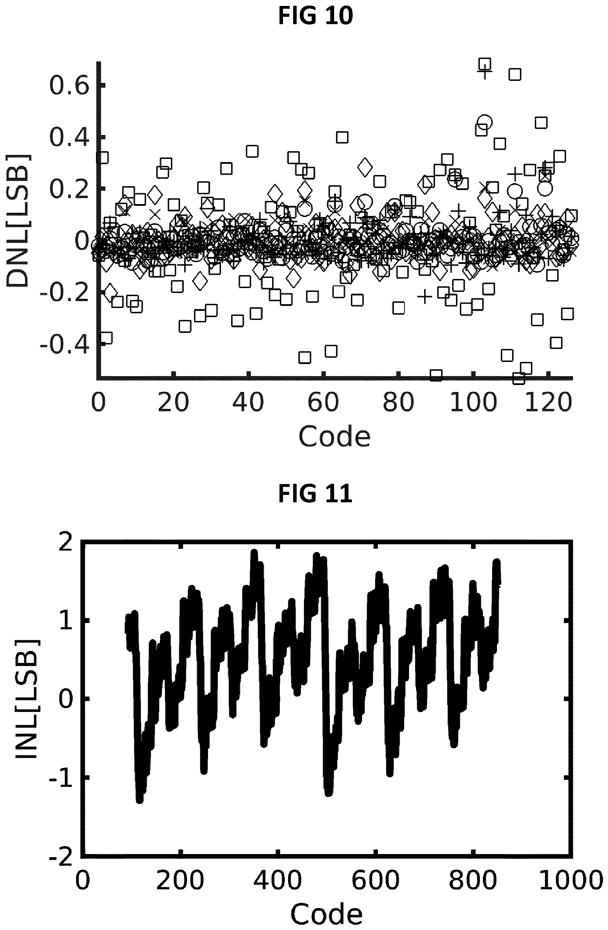

The measured range and non-linearity of one PMOS IDAC is shown in FIG 9 and FIG 10. The measured current ranges from 77pA to $132.4 \mu A$ with -0.53 / 0.68 Least Significant Bit (LSB) differential nonlinearity (DNL) for each input current source (*Iin*). The measured minimum current is limited by the measurement setup noise and is expected to be improved with a better insulated PCB design.

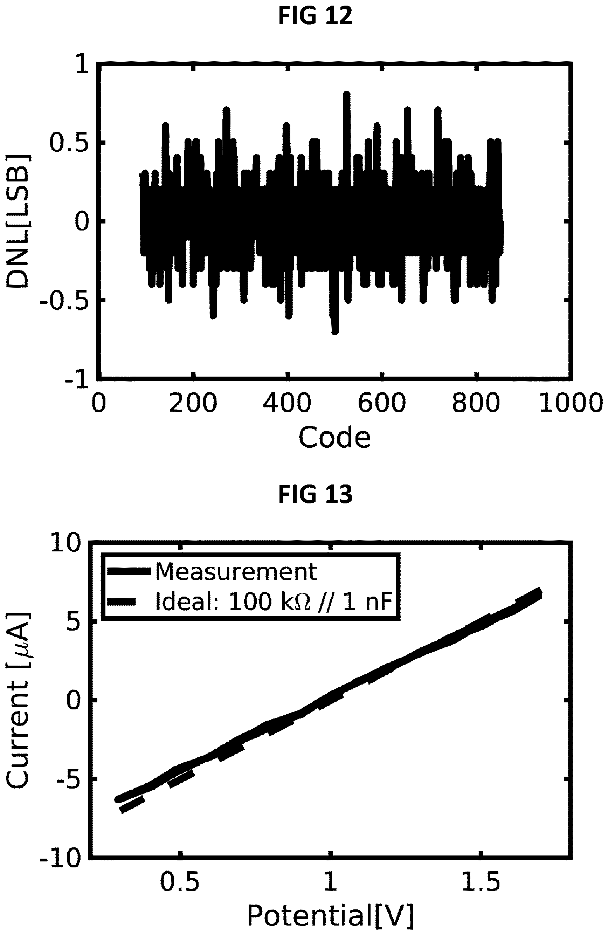

The measured non-linearity of one ADC is shown in FIG 11 and FIG 12, with 1.86 / - 1.29 LSB integral nonlinearity (INL) and 0.81 / -0.70 LSB DNL within a 2V swing.

### B. System functionality and bandwidth

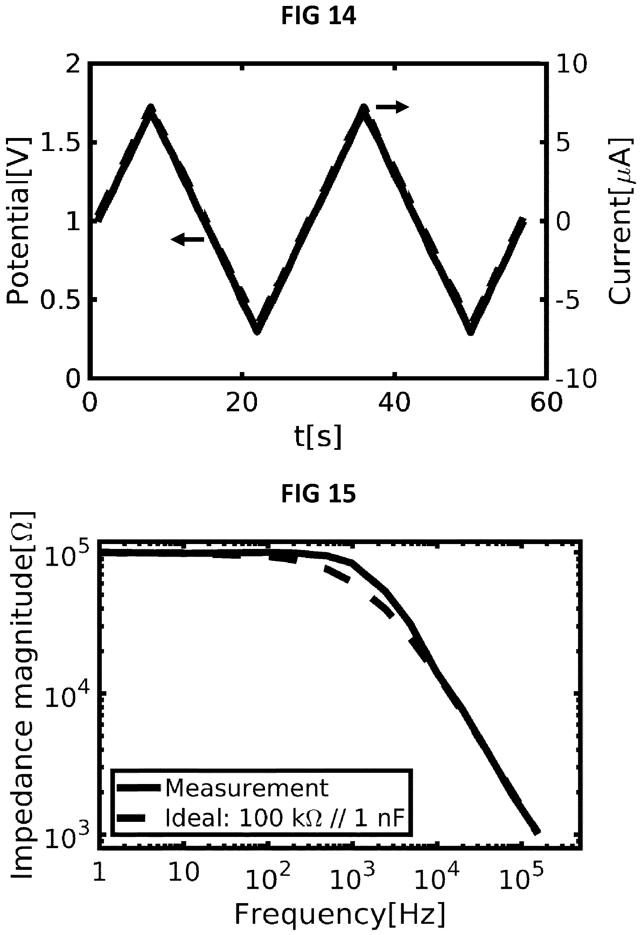

To prove the functionality and speed of the complete system when operating in feedback, a dummy load ($100k\Omega$ // 1nF) is connected to one WE. Then a ramp wave is applied to the digital feedback controller for 50mV/s cyclic voltammetry and sine waves from 1Hz to 150kHz are applied for impedance measurement. The ADC output and the IDAC input are extracted through SPI. The measurement results are shown in FIG 13-FIG 14 and FIG 15-FIG 16. The deviation with the ideal impedance curve can be attributed to parasitics in the setup and analog block non-idealities.

## V. CONCLUSION

The chip micrograph is shown in FIG 17. A comparison with the state-of-the-art is given in the table below (the references correspond to those as cited above).

| Reference | Lopez et al. | Giagkoulovits et al. | Manickam et al. | Jung et al. | **This example** |
|---|---|---|---|---|---|
| Process[nm] | 130 | 350 | 250 | 130 | **40** |
| Chip area[mm$^2$] | 19.2×10 | 3.79×3.79 | 7×9 | 5×5 | **3.06×2.76** |
| WE connection | on-chip | on-chip | on-chip | on-chip | **on-chip + off-chip** |
| Number of WE | 16384 | 256 | 1024 | 512 | **96** |
| Number of independent channels | 64 | 16 | 1 | 16 | **96** |
| Imax[$\mu$A]/Imin[pA] | 300/29000 | 13/1390 | 0.0125/0.28 | 0.06/2 | **132/77** |
| Current dynamic range[dB] | 80.3 | 82.6 | 93 | 89.5 | **125** |
| Measured voltage swing[V] | 3.0 | 5.2 | 1.5 | 1.2 | **2** |
| Max. Bandwidth[Hz] | 300~10k | 150k | 50 | 100k | **150k** |
| Max. Power consumption [mW] | 95 | 125 | 256 | 36 | **93** |

Compared to the state-of-the-art, more independent electrochemical monitoring channels and a larger current dynamic range are achieved with sufficient high bandwidth. The implementation in a more advanced technology enables the inclusion of a flexible digital feedback loop and fully programmable digital waveform generators for each channel with limited area. The design is highly scalable to larger measurement resolution with improved design of the IDAC and ADC.

It is to be understood that although preferred embodiments, specific constructions, configurations and materials have been discussed herein in order to illustrate the present invention. It will be apparent to those skilled in the art that various changes or modifications in form and detail may be made without departing from the scope of the invention as defined in the appended claims.

## Claims

1. A method for reading out a waveform, comprising:

   (a) converting the waveform into discrete digital output data (10);
   (b) buffering the discrete digital output data (10) by

   (b1) storing a first $n$ consecutive data points $[d_1, d_2, ..., d_n]$ (11) in registers (21) in such a way that the registers (21) are in a state $[d_1, d_2, ..., d_n]$ at the end of step b1,
   (b2) adding a subsequent $n$ consecutive data points $[d_1, d_2, ..., d_n]$ (11) to the registers (21) in such a way that the registers (21) are in a state $[r_1, r_2, ..., r_n]$ at the start of step b2 and in a state $[r_1 + d_1, r_2 + d_2, ..., r_n + d_n]$ at the end of step b2, and
   (b3) optionally repeating step b2 a selected number of times; and

   (c) outputting (40) the data accumulated in the registers (21).

2. The method according to claim 1, wherein the waveform is an electrical waveform.

3. The method according to any of the previous claims, wherein the waveform has a frequency of at least 1 kHz, preferably at least 10 kHz, more preferably at least 50 kHz, yet more preferably at least 100 kHz.

4. The method according to any of the previous claims, wherein step b2 is repeated $m$ - 2 times and comprising a further step d of:
(d) dividing (30) each datapoint outputted in step c by $m$ and outputting (40) the resulting data.

5. The method according to any of the previous claims, wherein steps a, b, c and-if present-d are cyclically repeated.

6. The method according to any of the previous claims, wherein $n$ consecutive data points (11) correspond to a period of the waveform or to an integer multiple of said periods.

7. The method according to any of the previous claims, wherein step b2 is repeated $m$ - 2 times and $m$ is at least 8, preferably at least 16, more preferably at least 32, most preferably at least 64.

8. A readout circuitry for a waveform sensor, comprising:

   (i) an analog-to-digital converter for converting a waveform into discrete digital output data (10); and
   (ii) an output buffer having a plurality of registers (21);

   wherein the readout circuitry is arranged for cyclically accumulating the digital output data in the plurality of registers (21).

9. The readout circuitry according to claim 8, wherein the waveform sensor is a potentiostat for measuring a periodic electrical signal.

10. The readout circuitry according to any of claims 8 to 9, implemented in an integrated circuit chip.

11. The readout circuitry according to any of claims 8 to 10, wherein the analog-to-digital converter is a successive-approximation analog-to-digital converter, a sigma-delta analog-to-digital converter or a noise-shaping successive-approximation analog-to-digital converter.

12. The readout circuitry according to any of claims 8 to 11, wherein the output buffer has at least 8 registers (21), preferably at least 16 registers (21), more preferably at least 32 registers (21), most preferably at least 64 registers (21).

13. A potentiostat, comprising the readout circuitry according to any of claims 8 to 12.

14. The potentiostat according to claim 13, being a multichannel potentiostat.

15. Use of an output buffer having a plurality of registers (21) in a readout circuitry for a waveform sensor, the readout circuitry-in operation-outputting data, for reducing a data rate to output said data.

**FIG 1**

**FIG 2**

## FIG 3

## FIG 4

## FIG 5

## FIG 6

offchip 10µ source

Shared for all channels

| | 100p | | 10n | | 1µ |
|---|---|---|---|---|---|
| 10p | | 1n | | 100n | |

B[9:7]

Mux

Iin

| x2 | | x8 | | x32 | |
| x1 | | x4 | | x16 | | x64 |

Switch bank

B[10]

Logic

B[6:0]

Iout

WE

Iout

Switch bank

| x2 | | x8 | | x32 | |
| x1 | | x4 | | x16 | | x64 |

Iout

Ioutn

Iout    Ioutn

B[i]

Bn[i]

Vin

EP 4 145 142 A1

## FIG 7

RE

WEs

Mux

6.6kΩ

3.3kΩ

10b CDAC

VCM

Logic

D_RE

D_WE

## FIG 8

## FIG 9

## FIG 10

## FIG 11

EP 4 145 142 A1

**FIG 12**

**FIG 13**

## FIG 14

## FIG 15

## FIG 16

## FIG 17

Europäisches
Patentamt

European
Patent Office

Office européen
des brevets

## EUROPEAN SEARCH REPORT

**Application Number**

**EP 21 19 4949**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2005/024249 A1 (PAVICIC MARK J [US])<br>3 February 2005 (2005-02-03)<br>* paragraph [0032] – paragraph [0143];<br>figures 4, 7, 8 *<br>----- | 1-12,15<br><br>13,14 | INV.<br>G01R13/02<br>G01R19/25<br>H03M3/00<br>G01N27/00 |
| A | MOLDEREZ TOM R ET AL: "An Affordable Multichannel Potentiostat with 128 Individual Stimulation and Sensing Channels",<br>2020 IEEE INTERNATIONAL INSTRUMENTATION AND MEASUREMENT TECHNOLOGY CONFERENCE (I2MTC), IEEE,<br>25 May 2020 (2020-05-25), pages 1-6,<br>XP033785992,<br>DOI: 10.1109/I2MTC43012.2020.9129564<br>[retrieved on 2020-06-29]<br>* the whole document *<br>----- | 1-15 | |
| A | CN 109 991 458 B (UNIV ELECTRONIC SCI & TECH CHINA) 31 July 2020 (2020-07-31)<br>* abstract *<br>----- | 1-15 | |
| A | LI PEISHUO ET AL: "A 64-channel, 1.1-pA-accurate On-chip Potentiostat for Parallel Electrochemical Monitoring",<br>ESSCIRC 2019 – IEEE 45TH EUROPEAN SOLID STATE CIRCUITS CONFERENCE (ESSCIRC), IEEE,<br>23 September 2019 (2019-09-23), pages 317-320, XP033660808,<br>DOI: 10.1109/ESSCIRC.2019.8902687<br>[retrieved on 2019-11-15]<br>* the whole document *<br>----- | 1-15 | TECHNICAL FIELDS SEARCHED (IPC)<br><br>G01R<br>H03M<br>G01N |

The present search report has been drawn up for all claims

| Place of search | Date of completion of the search | Examiner |
|---|---|---|
| Munich | 22 February 2022 | Meggyesi, Zoltán |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
 
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 21 19 4949

This annex lists the patent family members relating to the patent documents cited in the above-mentioned European search report.
The members are as contained in the European Patent Office EDP file on
The European Patent Office is in no way liable for these particulars which are merely given for the purpose of information.

22-02-2022

| Patent document cited in search report | Publication date | Patent family member(s) | Publication date |
|---|---|---|---|
| US 2005024249 A1 | 03-02-2005 | US 2005024249 A1<br>WO 2006023874 A1 | 03-02-2005<br>02-03-2006 |
| CN 109991458 B | 31-07-2020 | NONE | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MOLDEREZ, TOM R. ; RABAEY, KORNEEL ; VERHELST, MARIAN. A.** Scalable 128-Channel, Time-Multiplexed Potentiostat for Parallel Electrochemical Experiments. *IEEE Transactions on Circuits and Systems I: Regular Papers,* 2021, vol. 68.3, 1068-1079
- A 16384-electrode 1024-channel multimodal CMOS MEA for high-throughput intracellular action potential measurements and impedance spectroscopy in drug-screening applications. **LOPEZ, CAROLINA MORA et al.** 2018 IEEE International Solid-State Circuits Conference-(ISSCC). IEEE, 2018, 464-466

- **GIAGKOULOVITS, CHRISTOS et al.** A 16 x 16 CMOS amperometric microelectrode array for simultaneous electrochemical measurements. *IEEE Transactions on Circuits and Systems I: Regular Papers,* 2018, vol. 65.9, 2821-2831
- 11.2 A CMOS biosensor array with 1024 3-electrode voltammetry pixels and 93dB dynamic range. **MANICKAM, ARUN et al.** 2019 IEEE International Solid-State Circuits Conference-(ISSCC). IEEE, 2019, 192-194
- 28.4 A CMOS Multimodality In-Pixel Electrochemical and Impedance Cellular Sensing Array for Massively Paralleled Synthetic Exoelectrogen Characterization. **JUNG, DOOHWAN et al.** 2020 IEEE International Solid-State Circuits Conference-(ISSCC). IEEE, 2020, 436-438